Europäisches Patentamt

European Patent Office

Office européen des brevets

(11) Numéro de publication: **0 268 625 B1**

# (12) FASCICULE DE BREVET EUROPEEN

(45) Date de publication de fascicule du brevet: **28.10.92**  (51) Int. Cl.5: **H01H 9/56, H03K 17/13**

(21) Numéro de dépôt: **87903333.0**

(22) Date de dépôt: **20.05.87**

(86) Numéro de dépôt internationale :
**PCT/FR87/00167**

(87) Numéro de publication internationale :
**WO 87/07428 (03.12.87 87/27)**

(54) **PROCEDE ET DISPOSITIF DE COMMANDE D'UN ELECTRO-AIMANT DONT L'EXCITATION, PAR UN COURANT ALTERNATIF, PROVOOUE LA MISE EN CONTACT DE DEUX PIECES.**

(30) Priorité: **21.05.86 FR 8607190**

(43) Date de publication de la demande:
**01.06.88 Bulletin  88/22**

(45) Mention de la délivrance du brevet:
**28.10.92 Bulletin  92/44**

(84) Etats contractants désignés:
**DE GB IT NL**

(56) Documents cités:
**EP-A- 0 170 925**
**US-A- 3 557 381**
**US-A- 4 543 493**

(73) Titulaire: **TELEMECANIOUE**
**43-45 Boulevard Franklin Roosevelt**
**F-92500 Rueil-Malmaison(FR)**

(72) Inventeur: **BATAILLE, Christian**
**19, rue de Versailles**
**F-92410 Ville d'Avray(FR)**
Inventeur: **BELBEL, Elie**
**11, rue des Econdeaux**
**F-93800 Epinay sur Seine(FR)**
Inventeur: **GAST, Jean-No[l**
**14, rue Paul Olivier**
**F-92500 Rueil Malmaison(FR)**
Inventeur: **LAURAIRE, Michel**
**43, rue du Capitaine Guynemer**
**F-92400 Courbevoie(FR)**

(74) Mandataire: **Marquer, Francis et al**
**Cabinet Moutard 35, Avenue Victor Hugo**
**F-78960 Voisins le Bretonneux(FR)**

## Description

La présente invention concerne un procédé et un dispositif de commande d'un électro-aimant dont l'excitation, par un courant alternatif, provoque la mise en contact de deux pièces.

Elle s'applique notamment à la commande des électro-aimants utilisés dans les contacteurs électriques dont la fermeture est obtenue à la suite de l'excitation de la bobine de l'électro-aimant par un courant alternatif, cette excitation provoquant l'application des contacts mobiles du contacteur sur les contacts fixes. Toutefois, l'invention ne se limite pas à ce type d'application. Elle peut, en effet, convenir à de nombreux autres dispositifs actionnés par un électro-aimant tels que, par exemple, des électrovannes.

Il s'avère que dans les dispositifs de ce genre, l'énergie mécanique communiquée à la partie mobile de l'électro-aimant pour provoquer la fermeture est variable selon l'angle de fermeture de l'interrupteur qui commande l'excitation de la bobine de l'électro-aimant, c'est-à-dire selon l'instant marquant le début de l'excitation, considéré dans la période correspondante du courant alternatif.

C'est la raison pour laquelle, à l'heure actuelle, on est obligé de dimensionner les électro-aimants de manière à les rendre opérationnels dans tous les cas de figure, y compris pour des angles de fermeture les plus défavorables.

Toutefois, outre l'augmentation du coût et de l'encombrement qu'implique ce dimensionnement, ces mesures présentent un certain nombre d'inconvénients principalement dus à l'excès d'énergie développée notamment lorsque l'angle de fermeture est favorable.

On constate en effet, qu'en raison de ce surcroît d'énergie, il se produit fréquemment dans les contacteurs un impact brutal des contacts mobiles sur les contacts fixes qui s'accompagne de rebondissements entraînant une usure prématurée. En outre, l'équipage mobile de contact et/ou l'armature de l'électro-aimant percutent la partie fixe de l'électro-aimant avec une vitesse élevée, ce qui provoque un rebondissement du circuit magnétique (croquage), un matage voire une rupture du circuit magnétique, ainsi qu'un bruit important.

Des problèmes similaires se posent également dans d'autres dispositifs à électro-aimant tels que des électrovannes qui sont alors le siège d'usure prématurée des joints d'étanchéité et de phénomènes de rebondissement plus accentués dus, en particulier, à l'élasticité desdits joints.

L'invention a donc pour but de supprimer ces inconvénients. A cet effet, elle part de la constatation qu'un électro-aimant du type susdit présente au moins un angle de fermeture privilégié conduisant à un actionnement optimal de l'équipage mobile associé à l'électro-aimant. Par conséquent, en imposant cet angle de fermeture privilégié, il devient possible de supprimer les inconvénients précédemment mentionnés.

Pour parvenir à ce résultat, l'invention propose un procédé pour la commande d'un électro-aimant comprenant une bobine sur laquelle peut être appliqué un courant alternatif à la suite de l'émission d'un ordre de commande, en vue de provoquer la mise en contact de deux pièces, ce procédé étant plus particulièrement caractérisé en ce qu'il comprend les étapes suivantes :

- la détermination préalable d'une période de temps qui correspond à un angle de commande d'excitation privilégié de l'électro-aimant ;
- la détection, à partir de l'instant où ledit ordre de commande a été émis, d'un passage à zéro du courant alternatif ;
- l'application du courant alternatif à la bobine, lorsque ladite période de temps succédant ledit passage à zéro s'est écoulée.

Ce procédé peut être mis en oeuvre en associant à un dispositif interrupteur commandable en série avec la bobine de l'électro-aimant, un circuit électronique relativement simple comprenant :

- un organe de détermination des zéro de tension du courant alternatif ;
- un élément de temporisation connecté à la sortie de l'organe de détermination de zéro, cet élément de temporisation étant réglé pour obtenir un temps de temporisation qui correspond à l'angle de commande privilégié de l'électro-aimant ;
- un dispositif de commutation commandé par l'élément de temporisation pour délivrer au dispositif interrupteur, a la suite d'un ordre de commande, un signal de commande d'excitation de la bobine retardé dudit temps de temporisation.

La maîtrise ainsi obtenue de la vitesse communiquée à l'équipage mobile de contact et/ou à l'armature mobile permet d'éviter les inconvénients précédemment cités.

Des essais effectués sur de tels dispositifs ont montré qu'il était possible de multiplier jusqu'à dix la durée de vie de l'appareil et, d'autre part, de réduire considérablement le volume et le prix de l'électro-aimant, du fait notamment de la diminution du volume de cuivre requis.

Des modes de réalisation de l'invention seront décrits ci-après, à titre d'exemples, avec référence aux dessins annexés dans lesquels :

La figure 1 est un schéma de principe d'un dispositif de commande conforme à l'invention ;

La figure 2 est un diagramme représentatif des signaux électriques en différents points du circuit représenté sur la figure 1 ;

Les figures 3, 4, 5 et 6 sont des schémas de variantes d'exécution de l'interrupteur commandable utilisé dans les dispositifs représentés sur les figures 1 et 2.

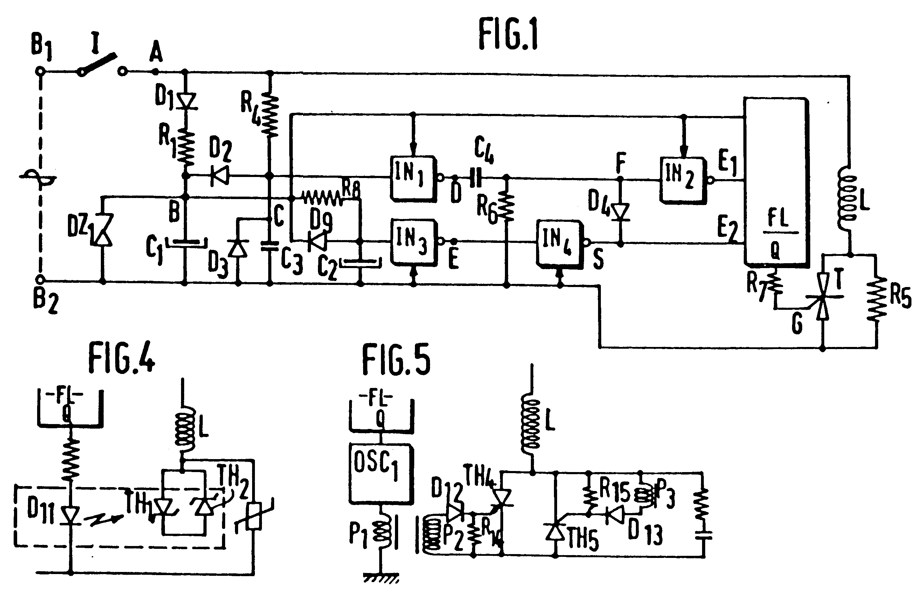

Tel que représenté sur la figure 1, le dispositif de commande pour électro-aimant dont seule la bobine L a été représentée, fait intervenir, en série dans un circuit reliant la bobine L aux bornes d'une source de courant alternatif (bornes $B_1$, $B_2$), un interrupteur de commande I dont la fermeture est obtenue par application d'un ordre d'excitation de la bobine et un interrupteur commandable constitué par un Triac T shunté, de façon classique, par une résistance RS ("Snubber") destinée à éviter un déclenchement intempestif par $\frac{dV}{dt}$ du Triac T lors de la fermeture de l'interrupteur de commande I.

La gâchette G de ce Triac T est commandée par un circuit électronique de commande alimenté par un circuit d'alimentation connecté entre la borne de sortie A de l'interrupteur I et la borne $B_2$ de la source. Ce circuit d'alimentation comprend notamment, en série, une diode $D_1$, une résistance $R_1$ et un condensateur $C_1$ shunté par une diode Zener $Dz_1$.

Dans cet exemple, la détection des zéros de tension de la source et l'obtention du susdit temps de temporisation définissant l'angle de commande privilégié de l'électro-aimant sont obtenus selon un processus comprenant les étapes suivantes :

- l'obtention d'un courant redressé demi-onde synchrone du courant alternatif de la source, mais déphasé par rapport à celui-ci d'un angle de déphasage correspondant à l'angle de commande privilégié ;
- la conformation dudit courant redressé en un signal crénelé présentant les mêmes caractéristiques de fréquence et en opposition de phase ;
- la dérivation du signal crénelé de manière à obtenir des impulsions correspondant aux fronts montants dudit signal ;
- la commande de la gâchette G du Triac T par une bascule bistable sensible auxdites impulsions.

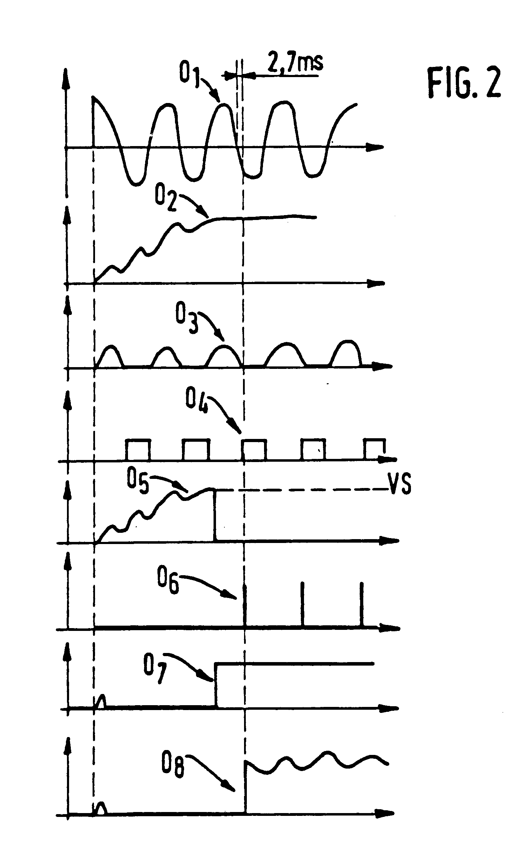

Ainsi, dans l'exemple représenté, la phase d'obtention du courant redressé est réalisée au moyen d'un circuit redresseur comprenant, entre les bornes A et $B_2$, une résistance $R_4$ et une diode $D_3$ en parallèle avec laquelle est monté un condensateur $C_3$. Le déphasage du courant redressé demi-onde obtenu au point C par rapport au courant alternatif du réseau peut être ajusté à la valeur souhaitée, par un choix approprié de la valeur de la résistance $R_4$ et/ou du condensateur $C_3$. Ce déphasage est visible sur les oscillogrammes $O_1$ et $O_3$ représentés sur la figure 2 qui représentent respectivement la tension du courant alternatif prélevée à la borne A et la tension redressée demi-onde obtenue au point C (jonction entre la résistance $R_4$ et le condensateur $C_3$).

Cette tension redressée demi-onde est appliquée à un premier conformateur inverseur $IN_1$ qui délivre au point D un signal crénelé synchrone mais en opposition de phase visible sur l'oscillogramme $O_4$. Ce signal est ensuite transmis à un dérivateur formé, de façon classique, par un condensateur $C_4$ et une résistance $R_6$. Au point F situé à la jonction du condensateur $C_4$ et de la résistance $R_6$, on obtient donc une succession d'impulsions qui correspondent respectivement aux fronts montants des créneaux du signal délivré par le conformateur inverseur $IN_1$.

Ces impulsions visibles sur l'oscillogramme $O_6$ sont ensuite appliquées à un deuxième conformateur inverseur $IN_2$ dont la sortie est connectée à l'entrée $E_1$ d'une bascule bistable FL de type RS. La sortie Q de cette bascule FL dont le signal est représenté par l'oscillogramme $O_8$ est connectée à la gâchette du Triac T par l'intermédiaire d'une résistance $R_7$.

L'entrée d'initialisation $E_2$ de cette bascule FL est connectée à un circuit d'initialisation agencé de manière à n'émettre un signal d'initialisation que, lorsque, à la suite de la fermeture de l'interrupteur I, la tension d'alimentation dépasse une valeur prédéterminée. Ce circuit d'initialisation comprend plus particulièrement, entre le point B du circuit d'alimentation et la borne $B_2$, une résistance $R_8$ en série avec un condensateur $C_2$. Le point de jonction entre cette résistance $R_8$ et cette capacité $C_2$ est alors relié à un dispositif à seuil $IN_3$ qui délivre à sa sortie E une tension dont la variation a été représentée par l'oscillogramme $O_5$ et comprend une première phase qui suit l'instant de fermeture de l'interrupteur I, et au cours de laquelle la tension croît à l'image de la tension d'alimentation au point B (oscillogramme $O_2$) et une deuxième phase qui est déclenchée lorsque la tension atteint un seuil prédéterminé VS et au cours de laquelle cette tension présente une valeur nulle.

La sortie E du dispositif à seuil $IN_3$ est reliée à l'entrée d'un conformateur inverseur $IN_4$ qui fournit à sa sortie S une tension de sortie qui, comme on le voit sur l'oscillogramme $O_7$, présente une valeur nulle (état logique 0) dans la première phase de fonctionnement du dispositif à seuil $IN_3$ et une valeur correspondant à un état logique 1, au cours de la deuxième phase. Cette tension de sortie est appliquée à l'entrée d'initialisation $E_2$ de la bascule FL. On obtient donc ainsi une temporisation de l'initialisation de la bascule FL qui permet d'éviter un fonctionnement aléatoire de la bascule lors de la phase transitoire qui suit la fermeture de l'interrupteur I.

Une diode $D_4$ montée entre le point F (sortie du dérivateur $C_4 R_6$) et le point S interdit l'enclenchement de la bascule FL pendant tout le temps que l'initialisation qui doit s'opérer à la suite de la fermeture de l'interrupteur I n'est pas terminée (la diode $D_4$ maintient la sortie du dérivateur $C_4 R_6$ à une tension nulle pendant la première phase de fonctionnement du dispositif à seuil $IN_3$ et du conformateur inverseur $IN_4$).

Le circuit précédemment décrit comprend en outre :

- une diode $D_2$ reliant les points B et C de manière à limiter la tension au point C à la tension d'alimentation délivrée au point B ;
- une diode $D_9$, en parallèle avec la résistance $R_8$, qui sert à accélérer la décharge du condensateur $C_2$ lors de l'ouverture de l'interrupteur I.

Il convient de noter que sur les oscillogrammes représentés sur la figure 2, le temps de temporisation correspondant à l'angle de commande privilégié de l'électro-aimant a été choisi à 2,7 ms environ, ce qui correspond à un angle de 50°.

Bien entendu, l'invention ne se limite pas à cet angle. En effet, selon le type de dispositif à électro-aimant utilisé, cet angle peut varier de 0 à 180°.

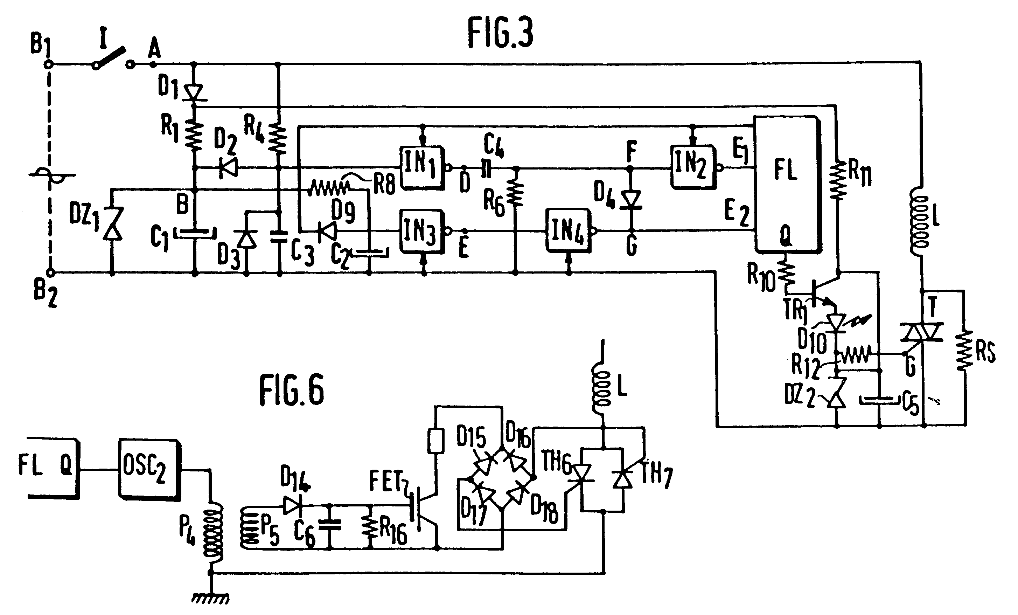

Dans la variante d'exécution représentée sur la figure 3, le courant de gâchette du Triac est amplifié par un transistor $TR_1$ dont la base est reliée à la sortie Q de la bascule FL, par l'intermédiaire d'une résistance $R_{10}$. Le collecteur de ce transistor $TR_1$ est connecté à la diode $D_1$ par l'intermédiaire d'une résistance $R_{11}$ et à la borne $B_2$ de la source de courant alternatif, par l'intermédiaire d'un condensateur $C_5$ shunté par une diode Zener $Dz_2$. L'émetteur du transistor $TR_1$ est alors connecté à la gâchette du Triac T par l'intermédiaire d'une résistance $R_{12}$ et d'une diode électroluminescente $D_{10}$ qui permet la visualisation de l'état de la commande du Triac T.

Il convient de noter que la commande de l'électro-aimant pourrait s'effectuer autrement qu'à l'aide d'un Triac.

Ainsi, la figure 4 montre un exemple d'exécution dans lequel cette commande s'effectue au moyen d'un optocoupleur pouvant comprendre, de façon connue, une diode électroluminescente $D_{11}$ montée dans le circuit de sortie de la bascule FL et deux optothyristors $TH_1$, $TH_2$ montés tête-bêche dans le circuit de la bobine L.

La figure 5 représente une autre variante selon laquelle la bascule bistable FL provoque la mise en action d'un oscillateur ou d'un multivibrateur $OSC_1$ dont la sortie débite dans le primaire $P_1$ d'un transformateur. Celui-ci comprend alors deux enroulements secondaires $P_2$, $P_3$ pilotant deux thyristors respectifs $TH_4$, $TH_5$ montés tête-bêche dans le circuit de la bobine L de l'électro-aimant et ce, par l'intermédiaire de deux démodulateurs comprenant

une diode $D_{12}$, $D_{13}$ et une résistance $R_{14}$, $R_{15}$.

Une autre solution, représentée sur la figure 6, consiste à utiliser un transformateur sans fer à un seul enroulement secondaire dont le primaire $P_4$ est monté sur le circuit de sortie d'un oscillateur $OSC_2$ piloté par la bascule bistable FL. La tension aux bornes de l'enroulement secondaire $P_5$ est alors redressée et filtrée ($D_{14}$, $C_6$, $R_{16}$) puis appliquée à la gâchette d'un transistor à effet de champ FET. Ce transistor à effet de champ FET effectue la commande de deux thyristors montés tête-bêche $TH_6$, $TH_7$ dans le circuit de la bobine, par l'intermédiaire d'un pont de diodes $D_{15}$ à $D_{18}$.

Il s'avère que le procédé et le dispositif précédemment décrits sont particulièrement avantageux pour la commande des contacteurs utilisés dans des montages inverseurs.

En effet, ces montages font habituellement intervenir deux contacteurs à fonctionnement inverse, c'est-à-dire que la fermeture de l'un de ces contacteurs s'accompagne de l'ouverture de l'autre contacteur.

Or, dans ces montages, dans lesquels l'ouverture et la fermeture respectives des deux contacteurs s'effectuent simultanément, il existe un risque important de court-circuit dû au fait que la commutation du contacteur recevant l'ordre de fermeture se produit avant l'extinction de l'arc de coupure qui se produit au niveau des contacts du contacteur recevant l'ordre d'ouverture. Ainsi, par exemple dans le cas d'un montage inverseur pour courant monophasé, le circuit de phase se trouvera directement relié au neutre.

Ce danger est supprimé grâce à l'emploi, pour chacun des contacteurs du montage inverseur, d'un dispositif de commande selon l'invention. En effet, grâce à ces dispositifs de commande, la commutation du contacteur sollicité à la fermeture sera toujours retardée par rapport à la commutation du contacteur sollicité à l'ouverture, avec un temps de retard supérieur au temps d'extinction de l'arc de coupure de ce dernier contacteur, par suite du temps nécessaire à l'initialisation.

## Revendications

1. Procédé pour la commande d'un électro-aimant comprenant une bobine sur laquelle peut être appliqué un courant alternatif provenant d'une source à la suite de l'émission d'un ordre d'excitation, en vue de provoquer la mise au contact de deux pièces, caractérisé en ce qu'il comprend les étapes suivantes :

   - la détermination préalable d'une période de temps qui correspond à un angle de commande d'excitation privilégié de l'électro-aimant ;

- la détection, à partir de l'instant où ledit ordre de commande a été émis, d'un passage à zéro de la tension alternative de la source ;
- l'application du courant alternatif à la bobine, lorsque ladite période de temps succédant ledit passage à zéro s'est écoulée.

2. Procédé selon la revendication 1, caractérisé en ce que la détection du zéro de tension et l'obtention du susdit temps de temporisation définissant l'angle de commande privilégié de l'électro-aimant sont obtenus selon un processus comportant les étapes suivantes :
- l'obtention d'un courant redressé demi-onde synchrone du susdit courant alternatif mais déphasé par rapport à celui-ci d'un angle de déphasage correspondant à l'angle de commande privilégié ;
- la conformation dudit courant redressé en un signal présentant les mêmes caractéristiques de fréquence et de phase ;
- la commande de l'application du courant alternatif sur ladite bobine par un front montant ou descendant dudit signal.

3. Procédé selon la revendication 2, caractérisé en ce qu'il comprend la dérivation du signal crénelé, de manière à obtenir des impulsions de courant qui coïncident dans le temps avec les fronts montants dudit signal et la commande de l'application du courant alternatif sur la bobine par l'un desdites impulsions.

4. Procédé selon la revendication 3, caractérisé en ce qu'il comprend l'inhibition desdites impulsions au cours d'une période transitoire succédant à l'émission de l'ordre de commande.

5. Dispositif pour la commande d'un électro-aimant mettant en oeuvre le procédé selon la revendication 1 et comprenant une bobine reliée à une source d'alimentation en courant alternatif par l'intermédiaire d'un dispositif interrupteur commandable (T) en série avec la bobine (L) de l'électro-aimant, caractérisé en que que ledit dispositif interrupteur (T) est commandé par un circuit de commande comprenant :
- des moyens ($R_4$, $C_3$, $D_3$, $IN_1$, $C_4$, $R_6$, $IN_2$) de détermination des zéro de tension du courant alternatif et de temporisation, réglés pour obtenir un temps de temporisation qui correspond à l'angle de commande privilégié de l'électro-aimant ; et
- un dispositif de commutation (FL) commandé par l'élément de temporisation pour délivrer au dispositif interrupteur (T), à la suite d'un ordre de commande, un signal de commande d'excitation de la bobine retardé dudit temps de temporisation.

6. Dispositif selon la revendication 5, dans lequel la bobine de l'électro-aimant est reliée à une source de courant alternatif par l'intermédiaire d'un circuit comprenant en série un interrupteur (I) dont la fermeture est obtenue par application d'un ordre d'excitation de la bobine et d'un dispositif interrupteur commandable (T), caractérisé en ce que la commande dudit dispositif interrupteur commandable (T) est assurée au moyen d'un circuit comprenant :
- à la sortie dudit interrupteur (I), un redresseur ($R_4$, $C_3$, $D_3$) apte à fournir un courant redressé demi-onde synchrone du courant alternatif de ladite source, mais déphasé par rapport à celui-ci d'un angle de déphasage correspondant à un angle de commande privilégié de l'électro-aimant ;
- un premier conformateur ($IN_1$) apte à transformer le courant redressé demi-onde en un signal crénelé présentant les mêmes caractéristiques de fréquence et en opposition de phase ;
- un dérivateur ($C_4$, $R_6$) monté à la sortie dudit premier conformateur ($IN_1$), ce dérivateur ($C_4$, $R_6$) étant agencé de manière à délivrer des impulsions coïncidant avec les fronts montants ou descendants dudit signal crénelé ;
- une bascule bistable (FL) sensible auxdites impulsions dont la sortie effectue la commande dudit dispositif interrupteur commandable (T).

7. Dispositif selon la revendication 6, caractérisé en ce qu'il comprend en aval du susdit interrupteur (I) un circuit redresseur ($D_1$, $R_1$, $C_1$, $Dz_1$) servant à l'alimentation des éléments du circuit de commande du dispositif interrupteur commandable (T), ainsi qu'un dispositif à seuil ($IN_3$, $IN_4$) qui fournit à la susdite bascule bistable un signal d'initialisation lorsque la tension délivrée par le circuit redresseur ($D_1$, $R_1$, $C_1$, $Dz_1$) dépasse un seuil prédéterminé, à la suite de la fermeture du susdit interrupteur (I).

8. Dispositif selon la revendication 7, caractérisé en ce qu'il comprend des moyens

($D_4$) permettant d'inhiber les susdites impulsions pendant la phase transitoire comprise entre le moment de fermeture de l'interrupteur (I) et l'instant où s'effectue l'initialisation de ladite bascule (FL).

9. Dispositif selon la revendication 5,
caractérisé en ce que le susdit dispositif interrupteur commandable consiste en un Triac (T) dont la gâchette (G) est commandée par le circuit de sortie de la bascule bistable (FL).

10. Dispositif selon la revendication 5,
caractérisé en ce que le susdit dispositif interrupteur commandable comprend un optocoupleur ($D_{11}$, $TH_1$, $TH_2$).

11. Dispositif selon la revendication 10,
caractérisé en ce que le susdit dispositif interrupteur commandable comprend une diode électroluminescente ($D_{11}$) montée dans le circuit de sortie de la bascule bistable (FL) et deux optothyristors ($TH_1$, $TH_2$) montés tête-bêche dans le circuit de la bobine (L).

12. Dispositif selon la revendication 5,
caractérisé en ce que le susdit interrupteur commandable comprend un oscillateur ($OSC_1$) commandé par la bascule bistable (FL) et dont la sortie débite dans le primaire ($P_1$) d'un transformateur, et en ce que ce transformateur comprend deux enroulements secondaires ($P_2$, $P_3$) pilotant deux thyristors respectifs ($TH_4$, $TH_5$) montés tête-bêche dans le circuit de la bobine (L) de l'électro-aimant et ce, par l'intermédiaire de deux démodulateurs respectifs ($D_{12}$, $R_{14}$, $D_{13}$, $R_{15}$).

13. Dispositif selon la revendication 5,
caractérisé en ce que le susdit interrupteur commandable comprend un oscillateur ($OSC_2$) commandé par la bascule bistable (FL) et dont la sortie (Q) débite dans le primaire ($P_4$) d'un transformateur, un redresseur ($D_{14}$, $C_6$, $R_{16}$) servant à redresser et à filtrer la tension délivrée par le secondaire ($P_2$) de ce transformateur, un transistor à effet de champ (FET) pilote par la tension ainsi redressée et filtrée, ce transistor à effet de champ effectuant la commande de deux thyristors ($TH_6$, $TH_7$) montés tête-bêche dans le circuit de la bobine (L), par l'intermédiaire d'un pont de diodes ($D_{15}$ à $D_{18}$).

## Claims

1. A method for controlling an electromagnet including a coil to which may be applied an AC current coming from a source following the emission of an energization order, for causing the engagement of two parts, characterized in that it includes the following steps :
   - previous determination of a period of time which corresponds to a privileged energization control angle of the electromagnet ;
   - detection, from the moment when said control order has been emitted, of a zero cross-over of the AC voltage from the source ;
   - the application of the AC current to the coil, when said period of time following after said zero cross-over has elapsed.

2. Method according to claim 1,
characterized in that detection of the voltage zero and said delay time defining the privileged control angle of the electromagnet are obtained including the following steps :
   - -the provision of a half-wave rectified current synchronous with the above-mentioned AC current, but phase shifted with respect thereto by a phase shift angle corresponding to the privileged control angle ;
   - shaping of said rectified current into a signal having the same frequency and phase characteristics ;
   - control of the application of the AC current to said coil by means of a rising or falling front of said signal.

3. Method according to claim 2,
characterized in that it includes shunting of the square-wave signal so as to obtain current pulses which coincide in time with the rising fronts of said signal and controlling the application of the AC current to the coil by one of said pulses.

4. Method according to claim 3,
characterized in that it comprises inhibition of said pulses during a transitory period following the emission of the control order.

5. Device for controlling an electromagnet, implementing the method of claim 1 and having a coil connected to an AC supply source through a controllable switch device (T) in series with the coil (L) of the electromagnet,
characterized in that said switch device (T) is controlled by a control circuit including :
   - means ($R_4$, $C_3$, $D_3$, $IN_1$, $C_4$, $R_6$, $IN_2$) for determining the voltage zeros of the AC current and delay means adjusted so as to obtain a delay time which corresponds to the privileged control angle of the electromagnet ; and

- a switch-over device (FL) controlled by said delay element for delivering to the switch device (T) following a control order, a signal for controlling energization of the coil delayed by said delay time.

6. Device according to claim 5, in which the coil of the electromagnet is connected to an AC source through a circuit including in series a switch (I) whose closure is obtained by application of an order for energizing the coil and a controllable switch device (T), characterized in that control of said controllable switch device (T) is provided by means of a circuit comprising :

- at the output of said switch (I), a rectifier ($R_4$, $c_3$, $D_3$) adapted for delivering a half-wave rectified current synchronous with the AC current of the source, but phase shifted with respect thereto by a phase shift angle corresponding to a privileged control angle of the electromagnet ;
- a first shaper ($IN_1$) adapted for transforming the rectified half-wave current into a square-wave signal having the same frequency characteristics and in phase opposition ;
- a shunting device ($C_4$, $R_6$) mounted at the output of said first shaper ($IN_1$), this shunting device ($C_4$, $R_6$) being adapted so as to deliver pulses coinciding with the rising or falling fronts of said square wave signel ;
- a bistable flip-flop (FL) responsive to said pulses whose output controls said controllable switch device (T).

7. Device according to claim 6, characterized in that it comprises downstream of said switch (I) a rectifier circuit ($D_1$, $R_1$, $C_1$, $Dz_1$) for supplying the elements of the control circuit of the controllable switch device (T), as well as a threshold device ($IN_3$, $IN_4$) which delivers an initialization signal to said bistable flip-flop when the voltage delivered by the rectifier circuit ($D_1$, $R_1$, $C_1$, $Dz_1$) exceeds a predetermined threshold, following closure of said switch (I).

8. Device according to claim 7, characterized in that it comprises means ($D_4$) for inhibiting said pulses during the transitory phase between the time of closure of the switch (I) and the time when initialization of said flip-flop (FL) takes place.

9. Device according to claim 5, characterized in that said controllable switch device consists of a triac (T) whose gate (G) is controlled by the output circuit of the bistable flip-flop (FL).

10. Device according to claim 5, characterized in that said controllable switch device includes an optocoupler ($D_{11}$, $TH_1$, $TH_2$).

11. Device according to claim 10, characterized in that said controllable switch includes a light emitting diode ($D_{11}$) connected in the output circuit of the bistable flip-flop (FL) and two optothyristors ($TH_1$, $TH_2$) connected head to tail in the circuit of the coil (L).

12. Device according to claim 5, characterized in that said controllable switch includes an oscillator ($OSC_1$) controlled by the bistable flip-flop (FL) and the output of which feeds into the primary ($P_1$) of a transformer, and in that this transformer has two secondary windings ($P_2$, $P_3$) driving the respective thyristors ($TH_4$, $TH_6$) connected head to tail in the circuit of the coil (L) of the electromagnet through two respective demodulators ($D_{12}$, $R_{14}$, $D_{13}$, $R_{15}$).

13. Device according to claim 5, characterized in that the controllable switch includes an oscillator ($OSC_2$) controlled by the bistable flip-flop (FL) and the output (Q) of which feeds into the primary ($P_4$) of a transformer, a rectifier ($D_{14}$, $C_6$, $R_{16}$) for rectifying and filtering the voltage delivered by the secondary ($P_2$) of this transformer, a field effect transistor (FET) driven by the voltage thus rectified and filtered, this field effect transistor controlling two thyristors ($TH_6$, $TH_7$) connected head to tail in the circuit of the coil (L) through a diode bridge ($D_{15}$ to $D_{18}$).

**Patentansprüche**

1. Verfahren zur Steuerung eines Elektromagneten, der eine Spule aufweist, an die ein Wechselstrom angelegt werden kann, der nach der Aussendung eines Erregungsbefehls von einer Quelle kommt, um das Inberührungbringen von zwei Stücken zu bewirken, dadurch gekennzeichnet, daß es die folgenden Schritte aufweist:

- vorherige Bestimmung einer Zeitdauer, die einem privilegierten Erregungssteuerwinkel des Elektromagneten entspricht,
- Erfassung eines Nulldurchgangs der Wechselspannung der Quelle ausgehend von dem Zeitpunkt, an dem dieser Steuerbefehl ausgesandt wurde,
- Anlegen des Wechselstroms an die Spule, wenn diese auf den Nulldurchgang folgende Zeitdauer vergangen ist.

2. Verfahren nach Anspruch 1, dadurch gekennzeichnet, daß die Erfassung der Nullspannung und das Erhalten der den privilegierten Steuerwinkel des Elektromagneten definierenden Verzögerungszeit gemäß einem Verfahren erhalten werden, das folgende Schritte aufweist:
   - Erzeugung eines gleichgerichteten Halbwellenstroms synchron zum Wechselstrom, aber in Bezug auf diesen um einen Phasenverschiebewinkel verschoben, der dem privilegierten Steuerwinkel entspricht,
   - die Formung dieses gleichgerichteten Stroms in ein Signal, das die gleichen Frequenz- und Phasenmerkmale aufweist,
   - Steuerung des Anlegens des Wechselstroms an die Spule durch eine steigende oder fallende Flanke dieses Signals.

3. Verfahren nach Anspruch 2, dadurch gekennzeichnet, daß es die Differenzierung des Rechtecksignals, um Stromimpulse zu erhalten, die mit den steigenden Flanken dieses Signals in der Zeit zusammenfallen, und die Steuerung der Anlegung des Wechselstroms an die Spule durch einen dieser Impulse enthält.

4. Verfahren nach Anspruch 3, dadurch gekennzeichnet, daß es die Unterdrückung dieser Impulse während einer Übergangsperiode enthält, die auf die Aussendung des Steuerbefehls folgt.

5. Vorrichtung zur Steuerung eines Elektromagneten, die das Verfahren gemäß Anspruch 1 anwendet und eine Spule aufweist, die mit einer Wechselstrom-Speisequelle über eine steuerbare Schaltvorrichtung (T) in Reihe mit der Spule (L) des Elektromagneten verbunden ist, dadurch gekennzeichnet, daß diese Schaltvorrichtung (T) von einem Steuerkreis gesteuert wird, der aufweist:
   - Mittel ($R_4$, $C_3$, $D_3$, $IN_1$, $C_4$, $R_6$, $IN_2$) zur Bestimmung der Nulldurchgänge des Wechselstroms und der Verzögerung, die so eingestellt sind, daß eine dem privilegierten Steuerwinkel des Elektromagneten entsprechende Verzögerungszeit erhalten wird, und

- eine Schaltvorrichtung (FL), die vom Verzögerungselement gesteuert wird, um der Schaltvorrichtung (T) nach einem Steuerbefehl ein um diese Verzögerungszeit verzögertes Erregungssteuerungssignal der Spule zu liefern.

6. Vorrichtung nach Anspruch 5, in der die Spule des Elektromagneten mit einer Wechselstromquelle über einen Schaltkreis verbunden ist, der in Reihe einen Schalter (I), dessen Schließen durch Anlegen eines Erregungsbefehls an die Spule bewirkt wird, und eine steuerbare Schaltvorrichtung (T) aufweist, dadurch gekennzeichnet, daß die Steuerung dieser steuerbaren Schaltvorrichtung (T) mittels eines Schaltkreises geschieht, der aufweist:
   - am Ausgang dieses Schalters (I) einen Gleichrichter ($R_4$, $C_3$, $D_3$), der einen gleichgerichteten Halbwellenstrom liefern kann, welcher mit dem Wechselstrom dieser Quelle synchron, aber in Bezug auf diesen um einen Phasenverschiebewinkel verschoben ist, der einem privilegierten Steuerwinkel des Elektromagneten entspricht;
   - einen ersten Impulsformer ($IN_1$), der den gleichgerichteten Halbwellenstrom in ein Rechtecksignal umwandeln kann, das phasenverschoben die gleichen Frequenzmerkmale aufweist;
   - ein Differenzierglied ($C_4$, $R_6$), das am Ausgang dieses ersten Impulsformers ($IN_1$) angeordnet ist, wobei dieses Differenzierglied ($C_4$, $R_6$) so ausgebildet ist, daß es Impulse liefert, die mit den ansteigenden oder abfallenden Flanken dieses Rechtecksignals zusammenfallen;
   - eine auf diese Impulse ansprechende bistabile Kippstufe (FL), deren Ausgang die steuerbare Schaltvorrichtung (T) steuert.

7. Vorrichtung nach Anspruch 6, dadurch gekennzeichnet, daß sie hinter diesem Schalter (I) einen Gleichrichterkreis ($D_1$, $R_1$, $C_1$, $Dz_1$), der zur Speisung der Elemente des Steuerkreises der steuerbaren Schaltvorrichtung (T) dient, und eine Schwellenvorrichtung ($IN_3$, $IN_4$) aufweist, die der bistabilen Kippstufe ein Initialisierungssignal liefert, wenn die vom Gleichrichterkreis ($D_1$, $R_1$, $C_1$, $Dz_1$) gelieferte Spannung nach dem Schließen des Schalters eine vorbestimmte Schwelle überschreitet.

8. Vorrichtung nach Anspruch 7, dadurch gekennzeichnet, daß sie Mittel ($D_4$) aufweist, die es ermöglichen, die Impulse während der Übergangsphase zu hemmen, die zwischen dem Schließzeitpunkt des Schalters (I) und dem Zeitpunkt liegt, an dem die Initialisierung der Kippstufe (FL) durchgeführt wird.

9. Vorrichtung nach Anspruch 5, dadurch gekennzeichnet, daß die steuerbare Schaltvorrichtung aus einem Triac (T) besteht, dessen Gate (G) vom Ausgangskreis der bistabilen Kippstufe (FL) gesteuert wird.

10. Vorrichtung nach Anspruch 5, dadurch gekennzeichnet, daß die steuerbare Schaltvorrichtung einen Lichtkoppler ($D_{11}$, $TH_1$, $TH_2$) aufweist.

11. Vorrichtung nach Anspruch 10, dadurch gekennzeichnet, daß die steuerbare Schaltvorrichtung eine Elektrolumineszenzdiode ($D_{11}$), die in den Ausgangskreis der bistabilen Kippstufe (FL) eingebaut ist und zwei Lichtthyristoren ($TH_1$, $TH_2$) aufweist, die antiparallel im Kreis der Spule (L) angeordnet sind.

12. Vorrichtung nach Anspruch 5, dadurch gekennzeichnet, daß der steuerbare Schalter einen Oszillator ($OSC_1$) aufweist, der von der bistabilen Kippstufe (FL) gesteuert wird und dessen Ausgang in die Primärwicklung ($P_1$) eines Transformators mündet, und daß dieser Transformator zwei Sekundärwicklungen ($P_2$, $P_3$) aufweist, die zwei Thyristoren ($TH_4$ bzw. $TH_5$) steuern, welche antiparallel in den Kreis der Spule (L) des Elektromagneten eingebaut sind, und dies über je zwei Demodulatoren ($D_{12}$, $R_{14}$, $D_{13}$, $R_{15}$).

13. Vorrichtung nach Anspruch 5, dadurch gekennzeichnet, daß der steuerbare Schalter einen Oszillator ($OSC_2$), der von der bistabilen Kippstufe (FL) gesteuert wird und dessen Ausgang (Q) in die Primärwicklung ($P_4$) eines Transformators mündet, einen Gleichrichter ($D_{14}$, $C_6$, $R_{16}$), der dazu dient, die von der Sekundärwicklung ($P_2$) dieses Transformators gelieferte Spannung gleichzurichten und zu filtern, und einen Feldeffekttransistor (FET) aufweist, der von der so gleichgerichteten und gefilterten Spannung gesteuert wird, wobei dieser Feldeffekttransistor über eine Diodenbrücke ($D_{15}$ bis $D_{18}$) zwei Thyristoren ($TH_6$, $TH_7$) steuert, die antiparallel im Kreis der Spule (L) angeordnet sind.

FIG.1

FIG.4

FIG.5

EP 0 268 625 B1

FIG. 2

FIG.3

FIG.6